# EUROPEAN PATENT SPECIFICATION

(11) **EP 0 496 382 B1**
(45) Date of publication and mention of the grant of the patent: **16.12.1998**
(21) Application number: 92101022.9
(22) Date of filing: 22.01.1992
(51) Int. Cl.: H01L 21/322, H01L 21/205

(54) **Intrinsic gettering for a semiconducteur epitaxial wafer**
Eigengetterung für ein epitaxiales Halbleiterplättchen
Piégeage intrinsique pour une tranche épitaxiée semi-conductrice

(30) Priority: 22.01.1991 JP 5494/91
(43) Date of publication of application: 29.07.1992
(73) Proprietor: NEC CORPORATION, Tokyo (JP)
(72) Inventor: Toeda, Masahiro, Minato-ku, Tokyo (JP)
(74) Representative: Glawe, Delfs, Moll & Partner

(56) References cited:
- GB-A- 2 080 780
- PATENT ABSTRACTS OF JAPAN vol. 12, no. 342 (E-658)14 September 1988 & JP-A-63 104 322 ( TOSHIBA CORP ) 9 May 1988
- PATENT ABSTRACTS OF JAPAN vol. 10, no. 42 (E-382)19 February 1986 & JP-A-60 198 832 ( NIPPON DENKI ) 8 October 1985
- PATENT ABSTRACTS OF JAPAN vol. 12, no. 481 (E-694)15 December 1988 & JP-A-63 198 334 ( KOMATSU DENSHI KINZOKU ) 17 August 1988

## Description

The present invention relates to a manufacturing method of a semiconductor epitaxial wafer, and more particularly, to a manufacturing method of an epitaxial wafer which is given an intrinsic gettering effect.

The process for getting rid of impurities or defects, like alkali metals such as Na, heavy metals such as Fe, or crystal defects, that are harmful to semiconductor devices is generally called gettering. In particular, the process for creating segregation spots by utilizing super-saturated oxygen that are-intrinsic to an Si wafer is called intrinsic gettering.

According to the intrinsic gettering, first, oxygen in the surface part is diffused out by subjecting a Si wafer containing super-saturated oxygen to a heat treatment, then oxygen in the interior of the wafer is derived out. As a result, a denuded zone which has neither oxygen deposition nor crystal defect is formed in the surface part that constitutes the device, while a sink for impurities and defects that have oxygen deposition and crystal defect at high density is formed in the interior of the wafer.

In the method of manufacturing a semiconductor device using the intrinsic gettering process first a silicon substrate with oxygen concentration of 12 to 15 x 10¹⁷/cm³ is prepared. The minute deposited nuclei that exist in the silicon substrate are removed by heat treatments first at a high temperature of 1150°C for about 3 hours, then at 650°C for about 24 hours to obtain a denuded zone free from deposited nuclei in the top and the bottom surfaces of the silicon substrate. Following that, an epitaxial layer is formed on the surface of the substrate.

Since resistivity of the substrate is set to be 0 to 0.018 Ω·cm and the resistivity of the epitaxial layer is set to be on the order of 15 Ω·cm in the prior art epitaxial wafer, it becomes necessary to raise the concentration of the impurity (for example, Sb) in the silicon substrate. As a result, the oxygen concentration in the silicon substrate to be used was in the range of 12 to 15 x 10¹⁷/cm³ for the reason of the relation between the concentration partial pressures.

In the conventional method of manufacturing an epitaxial wafer, silicon is epitaxially grown after heat treatments at a high and at a low temperatures of the silicon substrate having an oxygen concentration of 12 to 15 x 10¹⁷/cm³. Since there exist irregularities in the oxygen concentration of the silicon substrate, some uncertainity of the treatment time cannot be avoided. Thus, it is necessary to select an appropriate time for respective substrates so as to permit an adequate outward diffusion of oxygen, in the high temperature (for example, 1150°C) heat treatment. Moreover, a long heat treatment of about 24 hours was required for the low temperature (for example, 650°C) heat treatment because of the low oxygen concentration of 12 to 15 x 10¹⁷/cm³ of the silicon substrate. For these reasons, there was a problem that the productivity is poor and the cost becomes high for the epitaxial wafers.

Patents abstracts of Japan, Vol. 12, No. 342 (E-658), discloses a method for manufacturing a semiconductur wafer in which an epitaxial layer is adhered to an N-type silicon single crystal wafer having an oxygen concentration of 1.2 x 10¹⁸ to 2.0 x 10¹⁸ atoms/cm³. In this method heavy metal (Fe, Ni, Cr, etc.) in the layer tend to be gettered, and thus the life time of the layer is increased.

GB-A-2 080 780 discloses a method in which a two step heat treatment as mentioned before is performed, wherein in a first step oxygen is allowed to diffuse from the surface region of a silicon slice and in a second step lower in temperature than the first step defects are allowed to nucleate in the bulk of the slice.

Patents Abstracts of Japan, Vol. 10, No. 042 (E382), 1986, describes a method according to the preamble of claim 1. In particular, a method of gettering a wafer is disclosed including a high temperature and a low temperature step carried out on a substrate with an oxygen concentration of 12-18 x 10¹⁷ cm⁻³. By this treatment the oxygen concentration in a layer within a depth of 10 µm from the surface can be reduced to 5 x 10¹⁷ cm⁻³ or less.

It is an object of the invention to enhance the productivity and reduce the cost of the epitaxial wafer, and to carry out an intrinsic gettering processing after growing an epitaxial layer on a silicon substrate.

This object is achieved by a method as defined in claim 1.

According to a development of the present invention, an epitaxial layer is grown on a semiconductor substrate having an oxygen concentration of 16 - 19 x 10¹⁷ cm ⁻³ at a temperature above 1000°C, then subjected to an intrinsic gettering process. Thus, the heat treatment for intrinsic gettering needs to be carried out at low temperature of 650°C for only 1 hour, cutting down markedly the time for the heat treatment.

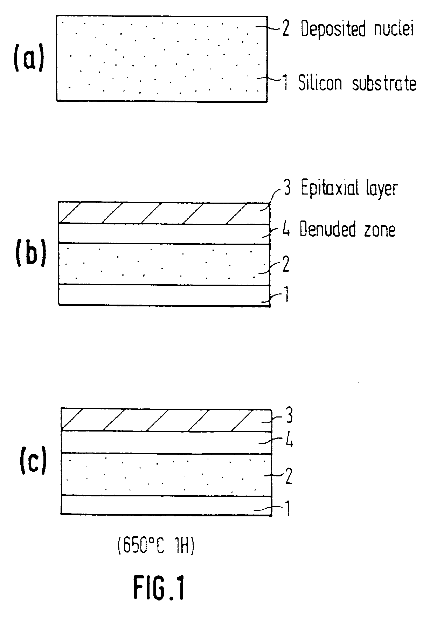

FIG. 1(a) ~ FIG. 1(c) show sectional views illustrating a preferred embodiment of the manufacturing method of an epitaxial wafer according to the present invention.

As shown in FIG. 1(a), an Sb-containing N-type silicon substrate 1 having an oxygen concentration of 16 to 19 x 10¹⁷/cm³ is prepared. This silicon substrate 1 includes minute deposited nuclei 2. Next, as shown in FIG. 1(b), an epitaxial layer 3 with thickness of about 15 µm is formed at 1150°C on the surface of the silicon substrate 1 by means of a chemical vapor deposition (CVD) method using, for example, SiHCℓ₃-H₂ gas. The temperature for this process suffices if it is 900 ~ 1200°C. This epitaxial growth process correspondes, in function, to the high temperature heat treatment at 1150°C in the prior art method. During this epitaxial growth process, there is formed a denuded zone 4 in the silicon substrate 1. Next, as shown in FIG. 1(c), deposited nuclei 2 are grown by a heat treatment at a low temperature of 650°C for 1 hour. For this heat treatment it is generally enough to heat at 650°C ~ 900°C for 1 hour - 5 hours in an atmosphere of nitrogen, oxygen, vapor and so on.

According to this embodiment, use is made as the silicon substrate 1 a substrate with oxygen concentration raised to a high level which facilitates the formation of the deposited nuclei, so that it is possible to cut down the time for heat treatment at the low temperature from the conventional value of about 24 hours to about 1 ~ 5 hours. Following the low temperature heat treatment, during the element manufacturing process, gettering of contaminating impurities and microdefects is continued to be carried out in the following heat treatments of the impurity-diffusion process, etc. From what has been described in the above, it can be seen that an enhancement of the productivity and a reduction of the manufacturing cost can be realized as a result of a sharp curtailment of the heat treatment time and a reduction of the process number. It should be noted that when the heat treatment time and the temperature of the element manufacturing process differ markedly from those of the aforementioned example, appropriate control, such as selection of the time for the low temperature heat treatment, may be needed to obtain sufficient intrinsic gettering effect.

It is to be further noted that the reason for setting the upper limit of the oxygen concentration of the silicon substrate at 19 x 10¹⁷/cm³ is that there will be generated surface defects in the epitaxial layer for oxygen concentration above that value.

As described in the above, this invention makes it possible to cut down the high temperature heat treatment which was required in the prior art and to reduce sharply the time of heat treatment at low temperature, by forming an epitaxial layer on the silicon substrate whose oxygen concentration is raised to 16 to 19 x 10¹⁷/cm³, then giving a heat treatment at low temperature. Therefore, this invention has an effect of enabling to enhance the productivity and to reduce the cost of the epitaxial wafers.

## Claims

1. A method for manufacturing a semiconductor wafer including a semiconductor substrate (1) containing oxygen in a concentration of 16 to 19 x 10¹⁷ cm⁻³, said method comprising the step of performing intrinsic gettering on said semiconductor wafer by first and second heat treatments, wherein the second heat treatment is carried out at a temperature lower than the first heat treatment,
**characterized** in that
said first heat treatment is carried out by growing an epitaxial layer (3) on said semiconductor substrate (1) and said second heat treatment is carried out for 1 hour to 5 hours.

2. A method for manufacturing a semiconductor wafer according to claim 1, wherein said semiconductor wafer is a silicon wafer and said epitaxial layer (3) is a silicon epitaxial layer.

3. A method for manufacturing an epitaxial wafer according to claim 1 or 2, wherein said epitaxial layer is grown at a temperature above 1000° C.

4. A method for manufacturing an epitaxial wafer according to claim 3, wherein said second heat treatment is carried out at 650°C to 900°C.

## Patentansprüche

1. Verfahren der Herstellung eines Halbleiterwafers mit einem Halbleitersubstrat (1), das Sauerstoff zu einer Konzentration von 16 - 19 x 10¹⁷cm⁻³ enthält, wobei das Verfahren einen Schritt zur Durchführung von Eigengetterung an dem Halbleiterwafer durch eine erste und eine zweite Wärmebehandlung umfaßt, wobei die zweite Wärmebehandlung bei einer Temperatur ausgeführt wird, die geringer ist als bei der ersten Wärmebehandlung,
dadurch **gekennzeichnet**, daß die erste Wärmebehandlung durch Ziehen einer epitaktischen Schicht (3) auf dem Halbleitersubstrat (1) durchgeführt wird und die zweite Wärmebehandlung für 1 - 5 Stunden durchgeführt wird.

2. Verfahren zum Herstellen eines Halbleiterwafers nach Anspruch 1,
wobei der Halbleiterwafer ein Siliziumwafer ist und die epitaktische Schicht (3) eine epitaktische Siliziumschicht ist.

3. Verfahren zur Herstellung eines epitaktischen Wafers nach Anspruch 1 oder 2,
wobei die epitaktische Schicht bei einer Temperatur oberhalb von 1000°C gezogen wird.

4. Verfahren zum Herstellen eines epitaktischen Wafers nach Anspruch 3,
wobei die zweite Wärmebehandlung bei 650°C bis 900°C durchgeführt wird.

## Revendications

1. Procédé de fabrication d'une plaquette semi-conductrice comportant un substrat semi-conducteur (1) contenant de l'oxygène dans une concentration de 16 à 19 x 10¹⁷ cm⁻³, ledit procédé comprenant l'étape consistant à effectuer un piégeage intrinsèque sur ladite plaquette semi-conductrice par des premier et deuxième traitements thermiques, le deuxième traitement thermique étant effectué à une température plus basse que le premier traitement thermique,
**caractérisé** en ce que
ledit premier traitement thermique est effectué en faisant croître une couche épitaxiale (3) sur ledit substrat semi-conducteur (1) et ledit deuxième traitement thermique est efectué pendant 1 à 5 heures.

2. Procédé de fabrication d'une plaquette semi-conductrice selon la revendication 1, dans lequel ladite plaquette semi-conductrice est une plaquette de silicium et ladite couche épitaxiale (3) est une couche épitaxiale de silicium.

3. Procédé de fabrication d'une plaquette épitaxiée selon la revendication 1 ou 2, dans lequel on fait croître ladite couche épitaxiale à une température supérieure à 1000 °C.

4. Procédé de fabrication d'une plaquette épitaxiée selon la revendication 3, dans lequel ledit deuxième traitement thermique est effectué à une température de 650 °C à 900 °C.
